# EUROPEAN PATENT APPLICATION

(11) **EP 3 702 489 A1**
(43) Date of publication of application: **02.09.2020**
(21) Application number: 19382144.4
(22) Date of filing: 27.02.2019
(51) Int. Cl.: C23C 14/10

(54) **HOUSING WALL FOR A HOUSING OF A HOME APPLIANCE**

(71) Applicant: BSH Hausgeräte GmbH, 81739 München (DE); BSH Electrodomésticos España, S.A., 50016 Zaragoza (ES)
(72) Inventor: Royo Sanchez, Raquel, 50017 Zaragoza (ES); Alonso Lozano, Sergio, 50006 Zaragoza (ES)

(57) **Abstract**

The present invention relates to a housing wall (1), particularly for a housing of a home appliance, comprising a substrate (2) and a protection layer (3) arranged on the substrate (2), wherein the material of the protection layer (3) comprises or is silicon oxide (SiOx).

## Description

The present invention relates to a housing wall for a housing of a home appliance. The invention also refers to such an housing for a home appliance. The invention further refers to a home appliance comprising such a housing. The invention also refers to a method for producing such a housing wall.

Modern household appliances are typically equipped with a model metal housing. The metal surface of the housing is usually cleaned frequently by the user of the household appliance to remove traces of use such as fingerprints or the like. This proves to be relatively costly with conventional metal surfaces and requires careful cleaning of the surface. In addition, the surfaces of conventional housing walls of housings for household appliances often prove to be unattractive for an observer.

It is therefore an object of the present invention to create a housing for a household appliance whose housing surface is particularly easy to clean for the user.

This problem is solved by the subject matter of the independent patent claims. Preferred embodiments are the subject matter of the dependent patent claims.

The basic idea of the invention is therefore to choose the raw material for a housing wall of an housing - this is referred to as "substrate" in the following - steel or aluminum and to coat it with silicon oxide (SiOx). In this way, surfaces can be created that are particularly resistant to dirt and can be cleaned very easily by the user of the appliance, especially after it has been used. This not only facilitates the handling of the housing and the use of the household appliance, but also provides a fine attractive appearance of the household appliance, especially if it is not in use.

A housing wall according to the invention, particularly for a housing of a home appliance, comprises a substrate and a protection layer arranged on the substrate. According to the invention, the material of the protection layer comprises or is silicon oxide (SiOx).

According to a preferred embodiment, the material of the substrate comprises or is aluminum. Aluminum is a metal that is commercially available at low cost and is also easy to process, making it very suitable for the manufacture of housing parts. In addition, aluminum is an excellent substrate for SiOx, as SiOx adheres very well to aluminum. Preferably, the material of the substrate is an aluminum alloy. It has been shown that SiOx has a particularly high abrasion resistance on an aluminium alloy, so that a surface particularly resistant to scratches can be produced.

According to another preferred embodiment, the substrate has been treated by black anodizing. In this way, the abrasion resistance of the surface can be improved.

According to another preferred embodiment, the material of the substrate comprises or is is stainless steel. In this way, a housing with enhanced robustness can be created.

Preferably, a layer thickness of the protection layer is in the range between 100nm and 200nm, preferably around 130nm. Experimental investigations have shown that a surface coating with such a layer thickness proves to be particularly wear-resistant. This is accompanied by a particularly long service life of.

The invention also refers to a housing for a home appliance. The housing comprises at least one housing wall according to the invention described above. The advantages of the housing wall described above are therefore also transferred to the inventive housing.

The invention also refers to a home appliance comprising a housing according to the invention and/or at least one housing wall according to the invention. The advantages of the housing described above are therefore also transferred to the inventive home appliance.

The invention also refers to a method for producing the previously discussed housing. The advantages of the housing described above are therefore also transferred to the inventive home appliance. According to the method, a protection layer comprising silicon oxide (SiOx) or consisting of silicon oxide (SiOx) is deposited on a substrate.

According to a preferred embodiment, the material of the substrate comprises or is aluminum. Aluminum is a metal that is commercially available at low cost and is also easy to process, making it very suitable for the manufacture of housing parts. In addition, aluminum is an excellent substrate for SiOx, as SiOx adheres very well to aluminum. Preferably, the material of the substrate is an aluminum alloy. It has been shown that SiOx has a particularly high abrasion resistance on a substrated consisting of an aluminium alloy, so that a surface particularly resistant to scratches can be produced.

Preferably, the material of the substrate is an aluminum alloy. It has been shown that SiOx has a particularly high abrasion resistance on an aluminium alloy, so that a surface particularly resistant to scratches can be produced.

According to a preferred embodiment, the deposition of the protection layer is achieved by means of Physical Vapour Deposition.

Preferably, the aluminum alloy is black anodized before deposition of the protection layer on the substrate. In this way, the abrasion resistance of the surface can be increased.

According to another preferred embodiment, the material of the substrate comprises or is stainless steel. Stainless steel is a particularly hard and therefore resistant metal making it very suitable for the manufacture of housing parts. In addition, aluminum is an excellent substrate for SiOx, as SiOx adheres very well to stainless steel.

Preferably, the stainless steel is cleaned and/or powder coated and/or cleaned anodized before deposition of the protection layer on the substrate.

Further important features and advantages of the invention can be gathered from the sub-claims, from the drawing and from the associated figure description using the drawing.

It goes without saying that the features mentioned above and those still to be explained below can be used not only in the respectively specified combination but also in other combinations or on their own without departing from the scope of the present invention.

Preferred examples of the execution of the invention are shown in the drawing and are explained in more detail in the following description.

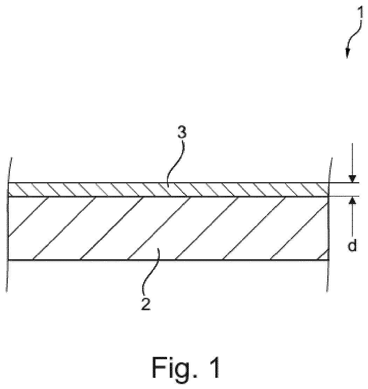

Figure 1 shows in a schematic view an example of a housing wall 1 according to the invention. The housing wall 1 can be part of a housing of a home appliance (not shown). The housing wall 1 comprises a substrate 2 and a protection layer 3 arranged on the substrate 2. The material of the substrate 2 comprises or is aluminum. Preferably, the material of the substrate can be an aluminum alloy. Alternatively, the material of the substrate 2 can be stainless steel. In both alternatives, the material of the protection layer 3 is silicon oxide (SiOx). A layer thickness d of the protection layer 3 is in the range between 100nm and 200nm, preferably around 130nm.

To manufacture the housing wall 1, the silicon oxide (SiOx) forming a protection layer 3 is deposited on the substrate 2. The SiOx, i.e. the protection layer 2, can preferably be deposited on the substrate 2 by means of Physical Vapour Deposition (PVD). In case that an aluminum alloy has been chosen as material for the substrate 2, the aluminum alloy can black anodized before deposition of the protection layer 3 on the substrate 2 by means of PVD. In case that stainless steel is chosen as material for the substrate 2, the stainless steel can be cleaned, powder coated and/or cleaned anodized before deposition of the protection layer 3 on the substrate 2 by means of PVD.

### LIST OF REFERENCE CHARACTERS/SIGNS

- 1: housing wall
- 2: substrate
- 3: protection layer
- d: layer thickness

## Claims

1. A housing wall (1), particularly for a housing of a home appliance, comprising a substrate (2) and a protection layer (3) arranged on the substrate (2), wherein the material of the protection layer (3) comprises or is silicon oxide (SiOx).

2. Housing wall according to claim 1, **characterized in that** the material of the substrate (2) comprises or is aluminum.

3. Housing wall according to claim 2, **characterized in that** the material of the substrate (2) is an aluminum alloy.

4. Housing wall according to any of claims 1 to 3, **characterized in that** the material of the substrate (2) is stainless steel.

5. Housing wall according to any of the preceding claims, **characterized in that** a layer thickness of the layer is in the range between 100nm and 200nm, preferably around 130nm.

6. Housing for a home appliance, comprising at least one housing wall (1) according to any of the preceding claims.

7. Home appliance, comprising a housing according to claim 6 and/or comprising at least one housing wall (1) according to any of claims 1 to 5.

8. Method for producing a housing wall according to any of claims 1 to 5 and/or for a housing according to claim 6, according to which silicon oxide (SiOx) forming a protection layer (3) is deposited on a substrate (2).

9. Method according to claim 8, **characterized in that** the material of the substrate (2) comprises or is aluminum.

10. Method according to claim 9, **characterized in that** the material of the substrate (2) is an aluminum alloy.

11. Method according to claim 1, **characterized in that** the deposition of the protection layer is achieved by means of Physical Vapour Deposition (PVD).

12. Method according to any of claims 9 to 11, **characterized in that** the aluminum alloy is black anodized before deposition of the protection layer (3) on the substrate (2).

13. Method according to claim 8, **characterized in that** the material of the substrate (2) comprises or is stainless steel.

14. Method according to claim 13, **characterized in that** the stainless steel is cleaned, powder coated and/or cleaned anodized before deposition of the protection layer (3) on the substrate (2).
